Europäisches Patentamt

European Patent Office

Office européen des brevets

(11) Publication number: **0 003 413**
A2

## EUROPEAN PATENT APPLICATION

(21) Application number: 79300091.0

(22) Date of filing: 18.01.79

(51) Int. Cl.²: **G 11 C 11/34**
H 01 L 27/10, H 01 L 29/60

(30) Priority: 19.01.78 US 870910

(43) Date of publication of application:
08.08.79 Bulletin 79/16

(84) Designated contracting states:
DE FR GB

(71) Applicant: SPERRY RAND CORPORATION
1290, Avenue of the Americas
New York N.Y. 10019(US)

(72) Inventor: Wegener, Horst Albrecht Richard
Apartment 108C 50 Resolute Circle
Rochester New York 14621(US)

(74) Representative: Michaels, Peter Albert
SPERRY UNIVAC Patent & Licensing Services M.S. S2
W1 SPERRY UNIVAC CENTRE
London NW10 8LS(GB)

(54) Improvements relating to semiconductor memories.

(57) The invention relates to variable-threshold semiconductor memory elements, and to memory arrays of such elements. The elements 117 may be arranged in an array 115 of rows 118 and columns 119. Each element comprises source and drain electrodes 130, fixed threshold access gate regions 38 and 39 respectively connected to row conductor 124 and column conductors 122 and a variable-threshold memory gate 31 connected to a row conductor 44. The conductors 122 and 124 permit adjoining elements to be written at different times, so that adjacent columns 119 need not be isolated from each other, and a common source-drain line 130 can serve as the drain electrode of one element and the source electrode of the next.

Fig.7

-1-

## Improvements relating to Semiconductor Memories

This invention relates to semiconductor memory elements, and to memories comprising arrays of such elements. In particular, the invention relates to insulated gate semiconductor elements employing variable threshold dielectric charge storage techniques. For examples of such elements and memories employing them, reference may be made to UK patents 1 231 227 and 1 306 997.

Present variable threshold memory elements accomplish write, erase and read functions through the application of appropriate voltage levels to a gate electrode overlying the variable threshold memory dielectric. In order to minimise read disturb and maximise retention of stored information, the read voltage level applied to the memory gate electrode should result in a minimum difference between stored threshold voltage and applied voltage. However, to minimise access time, the read current should be as large as possible, the magnitude of the read current being proportional to the difference of stored threshold voltage and applied voltage. Accordingly, if read current of a given variable threshold memory element is to be increased to improve access time, retention must be sacrificed.

The magnitude of the write voltage limits the number of write-erase cycles that a given variable threshold memory element can endure without unacceptable changes in electrical characteristics, so that it is desirable to decrease the write voltage to increase endurance. In order to obtain the necessary read current from the memory element, the read conditions must remain unchanged. Therefore, if endurance and access time are to be optimised, write and read voltage levels should be close to each other in value. However, read disturb increases as write and read voltage levels converge, the result being an undesirable decrease in retention.

Where high level write voltages are required, further disadvantages are a lower yield during manufacture as a consequence of the smaller number of devices that can be expected to meet the acceptance specifications, and higher power dissipation resulting from the application of a high level voltage. High level write and erase voltages applied to conventional variable threshold transistor memories also necessitate electrical separation of the substrate of the peripheral circuits from the memory array substrate. This is accomplished with the help of an epitaxial junction isolated laterally by diffused walls. This leads to additional steps in manufacture and higher yield losses associated with large epitaxial junctions.

The present invention provides a memory element, which may be a field effect transistor having source and drain electrodes, or a gated charge storage device with a single such electrode, in which the conduction channel has both a fixed threshold gate region and a variable threshold gate region, electrically separate from each other. This makes it possible to construct memory arrays giving a better compromise between the factors mentioned above.

The invention will now be further described with reference to the drawings, in which

Figure 1 is a cross-sectional view of a gated-access memory transistor in accordance with the present invention.

Figure 2 is a plan view of an array of gated-access memory transistors in accordance with the cross-section of Figure 1.

Figure 3 illustrates a process for fabricating an array of gated-access memory transistors.

Figure 4 is a cross-sectional view of a preferred embodiment of a gated-access memory transistor.

Figure 5 illustrates a process for fabricating the transistor of Figure 4.

Figure 6 is a plan view of an array of gated-access memory transistors fabricated in accordance with an unrestricted polycrystalline silicon process.

Figure 7 is a plan view of a preferred embodiment of an array of gated-access memory transistors fabricated in accordance with a self-aligned silicon-gate process.

Figure 8a is a schematic diagram of an array of depletion-mode gated-access memory transistors for explaining a writing scheme for use therewith.

Figure 8b is an exemplary pattern of information to be stored in the array of Figure 8a.

Figure 9 is a cross-sectional view of an array of gated-access, non-volatile charge storage devices in accordance with the present invention.

Figure 10 is a plan view of the array of Figure 9.

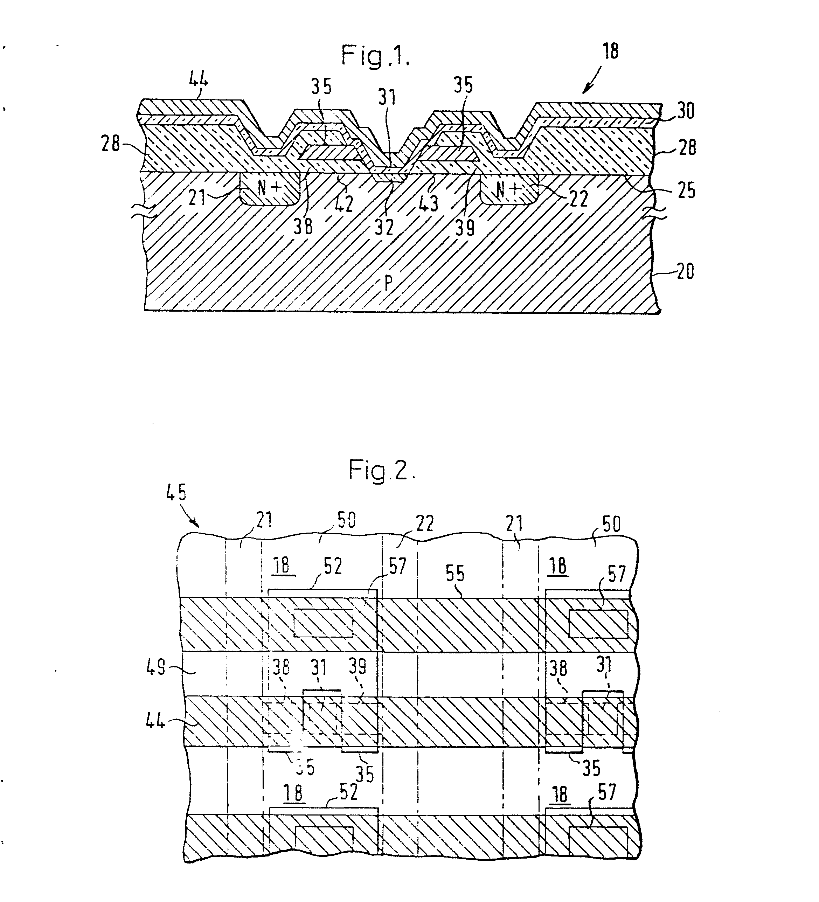

Figure 1 is a cross-sectional view of a gated-access memory transistor in accordance with the present invention. The illustrated device is an n-channel, insulated gate field effect transistor (IGFET) 18. The transistor 18 is fabricated on a substrate 20 of p-type silicon which may accommodate a plurality of such devices. The source region 21 and the drain region 22 are both $n^{+}$-type regions, and are formed through the surface 25 of the substrate 20, for example, by ion implantation. A layer of silicon dioxide 28 overlies the surface 25, except where a memory gate portion 31 of silicon nitride layer 30 overlies the surface 25 to form a depletion layer 32 in the substrate 20 adjacent to the surface 25, the depletion layer 32 resulting from positive charges stored in the silicon nitride layer 30. The silicon nitride layer 30 has a thickness of the order of 500 angstroms, and is substantially uniform over the silicon dioxide layer 28 and at the memory gate portion 31. A pair of polycrystalline silicon electrodes 35 overlie fixed threshold dielectric access gate regions 38 and 39 of the silicon dioxide layer 28. Access gate channel portions 42 and 43 of the substrate 20 lie immediately below the surface 25 and between the source region 21 and the depletion region 32 in the case of the access gate channel portion 42, and between the depletion region 32 and the drain region 22 in the case of the access gate channel portion 43. Polycrystalline silicon electrodes 35 provides means for applying a voltage to the fixed threshold dielectric access gate regions 38 and 39 in order to control the formation of inversion layers in the access gate channel portions 42 and 43, respectively, so as to control access to the depletion region 32 underlying the memory gate portion 31. As will be explained in connection with Figure 2, the polycrystalline silicon electrodes 35 are part of a single layer of polycrystalline silicon which applies the same voltage to the fixed threshold dielectric access gate regions 38 and 39. This layer of polycrystalline silicon has a thickness of the order of 5,000 angstroms, while the thickness of the fixed threshold dielectric regions 38 and 39 is of the order of 1,000 angstroms. A layer of aluminium 44 is deposited on the silicon nitride layer 30 and provides means for applying a voltage to it which is independent of the voltage applied by the polycrystalline silicon electrodes 35 to the fixed threshold dielectric regions 38 and 39.

Figure 2 illustrates a two-dimentional rectangular array 45 of gated-access, insulated gate field effect transistors 18 of the type illustrated in Figure 1 in cross-section, arranged in rows 49 and columns 50. The transistors 18 in each column 50 share common source regions 21 and common drain regions 22 of high impurity concentration n-type material to which ohmic contacts may be made at the edges of the array.

As mentioned above, the polycrystalline silicon gate electrodes 35 are integral with the polycrystalline silicon regions 52 and overlie the fixed threshold dielectric access gate regions 38 and 39. Ohmic contact with each polycrystalline silicon region in the row 49 is made by an aluminium line 55 through apertures 57 formed in the silicon dioxide layer 28 of Figure 1 on which the line 55 is deposited. An aluminium layer 44, as explained in connection with Figure 1, lies over the silicon nitride layer 30 and, as shown in Figure 2, provides means for applying a voltage to the memory gate portions 31 thereof in each transistor 18 in row 49.

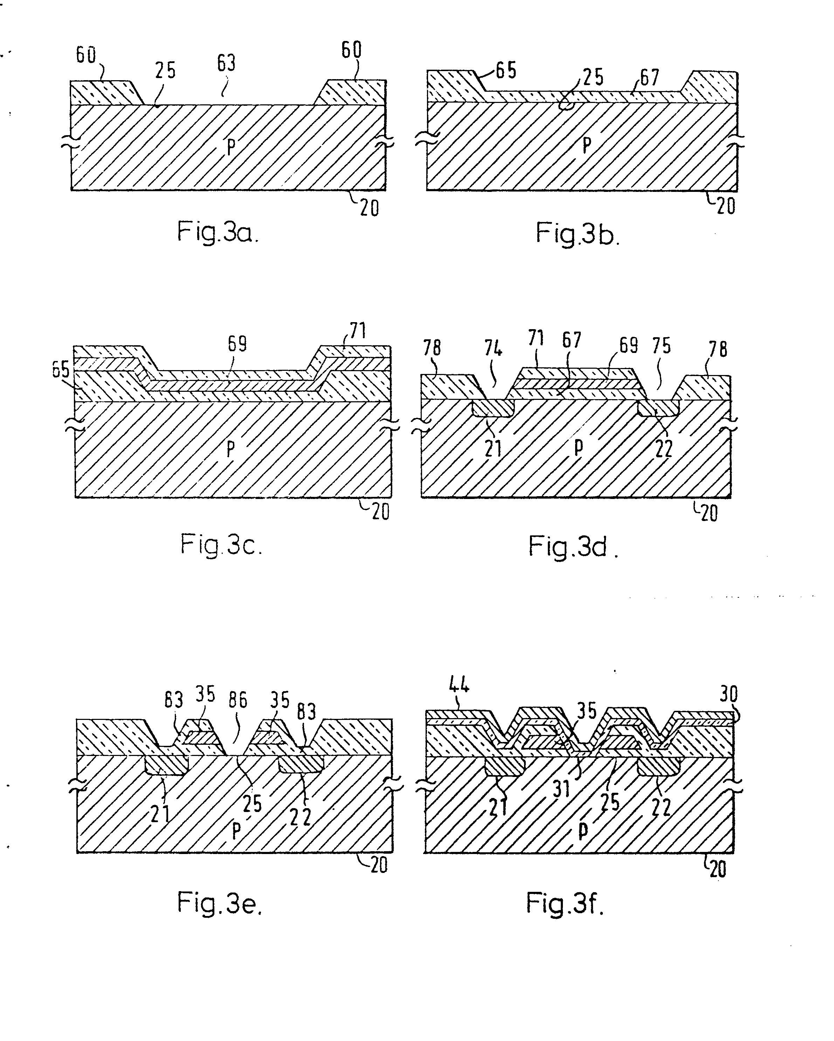

A preferred method of making the gated-access transistor of Figures 1 and 2 is described in connection with Figure 3. A thermal silicon dioxide layer 60 approximately 5,000 angstroms thick is grown on the surface 25 of a high resistivity p-type silicon substrate 20 and etched by conventional photoresist masking techniques to form an aperture 63 as shown in Figure 3a, to permit the formation of source, drain and gate regions. As shown in Figure 3b, a 1,200 angstrom layer of silicon dioxide is then grown on the silicon dioxide layer 60 and over the portion of the silicon surface 25 exposed by the aperture 63, to form a silicon dioxide layer 65, including a relatively thin gate oxide layer 67 covering the aperture 63. In order to provide the desired threshold voltage level for fixed threshold gate regions, boron atoms are implanted in the gate oxide layer 67 by ion implantation at the surface 25. With reference to Figure 3c, a layer of polycrystalline silicon 69 approximately 5,000 angstroms thick is deposited on the silicon dioxide layer 65, followed by deposition of an oxide layer 71, which is preferably thicker than 1,000 angstroms. Thereafter, portions of the layers 69 and 71 are selectively removed, along with portions of the silicon dioxide layer 67, as shown in Figure 3d, to form a source aperture 74 and a drain aperture 75. Those portions of the layers 69 and 71 over the field isolation regions 78 are also selectively removed. Source and drain regions 21 and 22 are then formed in the substrate 20 by n+ ion implantation. Next, another layer of silicon dioxide 83, approximately 1,000 angstroms thick, is grown on the exposed surface of the source region 21, the drain region 22 and the polycrystalline silicon region 69. Then, a memory gate aperture 86 is formed so as to expose the surface 25 of the substrate 20 at the memory gate region 31, and to define the polycrystalline silicon gate electrodes 35, formed by part of the polycrystalline silicon region 52, illustrated in Figure 2. Referring now to Figure 3f, a layer of silicon nitride 30 is deposited by conventional silane-ammonia vapour deposition techniques on the area of surface 25 exposed by the memory gate aperture 86 to form a memory gate portion 31, where it serves as a variable threshold memory gate dielectric; it is also deposited over exposed oxide surfaces as well as over the exposed walls of the polycrystalline silicon electrodes 35. The growth of oxide on the exposed portion of the surface 25 prior to formation of the silicon nitride layer 30 should be minimized. The silicon nitride layer 30 is preferably of the order of 500 angstroms thick. While other variable threshold dielectrics such as aluminium oxide may be used in place of silicon nitride, the latter is preferred. Next, an aperture 57 is formed in the silicon nitride layer 30 and in the oxide layer overlying the polycrystalline silicon region 52, as shown in Figure 2. The aluminium lines 44 and 55, shown in Figure 2, are formed by evaporation and patterned by photoresist etching to provide ohmic contacts, respectively, with the silicon nitride layer 30 and the polycrystalline silicon region 52.

While polycrystalline silicon is the preferred material for the electrodes 35 and the region 52, aluminium may also be used. In such a case, however, the silicon nitride layer 30 should be deposited at a temperature below the melting point of aluminium to preserve the integrity of the region 52.

Deterioration of the silicon dioxide dielectric as a result of exposure to radiation or inversion of the silicon surface in the field isolation regions 78, where the aluminium line 44 passes over the regions 78, may be minimised by placing a polycrystalline silicon layer beneath the aluminium line 44. This polycrystalline silicon layer should either be electrically floating, or should be connected to ground, to shield the oxide and the silicon surface beneath it from large write and erase voltages applied to the line 44.

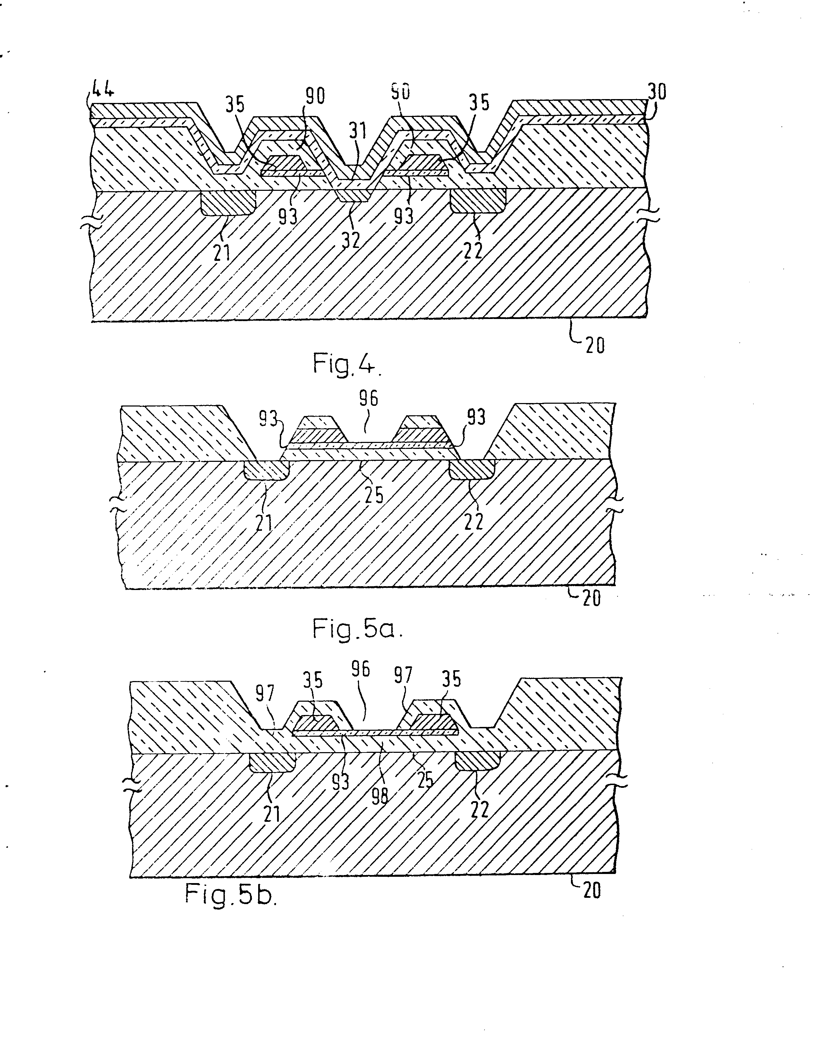

A preferred embodiment of a gated-access memory transistor is shown in Figure 4 in cross-section, elements corresponding to those illustrated in Figure 1 being identified by the same reference numerals. As shown in Figure 4, additional layers of silicon dioxide 90, having a thickness of approximately 1,000 angstroms, cover the side walls of the polycrystalline silicon electrodes 35 which, in the case of the embodiment of Figure 1, are covered by the silicon nitride layer 30. Additional layers of silicon nitride 93 lie beneath the electrodes 35 and the layers 90. The silicon dioxide layers 90 decrease the probability of premature dielectric breakdown in the silicon nitride layer 30 at the edges of its polycrystalline silicon electrodes 35.

In making the gated-access memory transistor illustrated in Figure 4, the process described in connection with Figure 3 is modified, in that after layer 65, shown in Figure 3b, is formed, a layer of silicon nitride of the order of 100 angstroms thick is deposited on it. Following the deposition of the layers 69 and 71 and the formation of the source region 21 and the drain region 22, a slot 96 is formed in layers 69 and 71, to expose the above mentioned 100 angstrom layer of silicon nitride (designated 93 in Figure 5a). A 2,000 angstrom layer of silicon dioxide 97 is next grown over the exposed side walls of the electrodes 35 (see Figure 5b) as well as over the exposed silicon dioxide surfaces and the exposed surface 25 of the substrate 20 in the areas of the source region 21 and the drain region 22. However, the silicon nitride layer 93 shields the area exposed by the slot 96 from further oxidation. Then the exposed portion of the silicon nitride layer 93 is removed selectively, either by the use of phosphoric acid (having relatively little effect on the exposed oxide) or by plasma etching techniques. The 1,000 angstrom layer 98 of silicon dioxide previously shielded by the now removed portion of the silicon nitride layer 93 is then removed to expose the substrate 20 where the memory gate portion 31 of the layer 30 will be formed, together with 1,000 angstroms of the silicon dioxide lying over the electrodes 35. However, 1,000 angstroms of oxide will remain over the electrodes 35. Thereupon, the process described in connection with Figure 3 is resumed to deposit the silicon nitride layer 30 and aluminium lines 44 and 55.

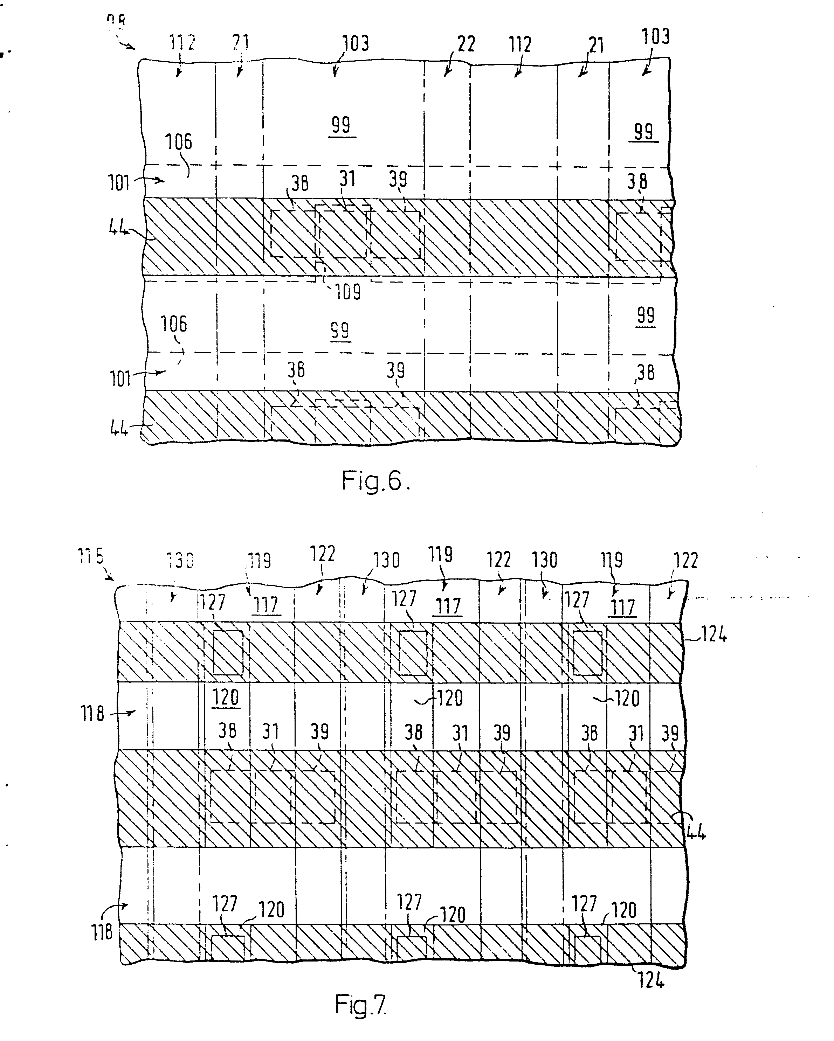

The size of the gated-access transistors may be reduced, and the need for ohmic contact to the individual fixed threshold gate electrode regions (such as regions 52 of Figure 2) may be eliminated by the arrangement of the gated-access transistor array 98 shown in Figure 6, made in accordance with an unrestricted polycrystalline silicon process. In Figure 6, elements corresponding to those shown in Figure 2 are identified by the same reference numerals.

The gated-access transistors 99 of Figure 6 are arranged in rows 101 and columns 103. As distinguished from the gated-access transistor array in Figure 2 made in accordance with the self-aligned polycrystalline silicon process of Figure 3, the transistor array 98 of Figure 6 is provided with a plurality of polycrystalline silicon lines 106, each corresponding to one of the rows 101. Each polycrystalline silicon line 106 overlies the fixed threshold dielectric access gate regions 38 and 39 of each transistor 99 in the respective row, while slots 109 are formed in the line so that it does not overlie the silicon nitride memory gate portions 31. Accordingly, a fixed

-8-

threshold access gate voltage applied to one of the polycrystalline silicon lines 106 will be applied to all the fixed threshold dielectric access gate regions 38 and 39 of the transistors in the row, but not to any of the the silicon nitride memory gate portions 31 in the row. As in the case of the array 45 of Figure 2, an aluminium line 44 overlies all the silicon nitride memory gate portions 31 in the row 101, while the fixed threshold dielectric access gate regions 38 and 39 are shielded from the line 44 by the polycrystalline silicon and line 106. Accordingly, a voltage may be applied by the polycrystalline silicon line 106 to its fixed threshold gate dielectric access gate regions 38 and 39 which is independent of the voltage applied by the aluminium line 44 to the memory gate portions 31.

The unrestricted polycrystalline silicon process for making the array of Figure 6 is a variation of a standard metal gate process used in the formation of memory transistors, modified to include an additional step in which the polycrystalline silicon line 106 is formed after the source and drain regions 21 and 22 have been formed. The lines 106 and 44 overlie not only the source and drain regions 21 and 22 but also field isolation silicon dioxide regions 112 lying between the source regions 22 and drain regions 21 of adjacent columns 103. The region 112 is shielded by the intervening polycrystalline silicon line 106 from large write and erase voltages applied to the line 44, and the radiation hardness and susceptibility to inversion of region 112 are thereby improved.

Figure 7 illustrates an array 115 of gated-access memory transistors 117 fabricated in accordance with a modified self-aligned silicon-gate process. The transistors 117 are arranged in rows 118 and columns 119. In place of the integral polycrystalline silicon region 52 of Figure 2 including electrodes 35 overlying fixed threshold dielectric access gate regions 38 and 39, each transistor 117 of Figure 7 is provided with a first access gate electrode line 120 of polycrystalline silicon which overlies the fixed threshold dielectric access gate region 38 and a second access gate electrode line 122 of polycrystalline silicon which overlies the fixed threshold dielectric access gate region 39. The electrode line 120 extends beyond the fixed threshold dielectric access gate region 38 to permit ohmic contact with a fixed threshold access gate aluminium line 124 which is arranged parallel to the aluminium line 44, and interconnects all the electrode lines 120 in the row 118. Apertures 127 are provided in an oxide layer overlying the electrode lines 120 to provide ohmic contacts with the line 124. Ohmic contacts with the electrode lines 122 are made at the edges of the array 115. Accordingly, it is possible in the case of the array of Figure 7 to address each individual gated-access transistor 117 separately by selecting one of the lines 124 and one of the lines 122 to turn on both access gates in only a single addressed transistor.

Common source-drain lines 130 are provided such that adjacent transistors in each row share the same region as source in one case and drain in the other. This is made possible by the provision of separate access gate electrode lines 120 and 122. That is, when it is desired to address the transistors in a given row, the access gate channel portions 42 underlying the dielectrics 38 are turned on by the application of an access gate voltage to the corresponding line 124 and one half of the transistors 117 in said row in alternating columns 119 may then be turned on by the application of an access gate voltage level to alternating access gate electrode lines 122, such that adjacent transistors 117 in the chosen row are not turned on simultaneously. Since adjacent transistors in a given row share source-drain regions 130 in the embodiment of Figure 7, field isolation regions are not provided between adjacent transistors in each row. It will be appreciated, therefore, that the embodiment of Figure 7 provides a relatively dense array of gated-access memory transistors which are fabricated in accordance with a self-aligned silicon-gate process.

It will be recognised that the gated-access transistors described in connection with Figures 1-7 and having a p-type substrate (n channel) and a depletion-mode operation, may also be fabricated as a p-channel depletion-mode device, wherein a p-type depletion channel is formed in an n-type substrate beneath the memory gate portion 31 of the silicon nitride layer 30. The p-type depletion channel should have a pinch-off voltage equal to the more negative threshold voltage of the variable threshold dielectric 30, so that when a zero voltage level is applied to the dielectric 30 by the line 44

-10-

after the variable threshold voltage has been set at the more negative value, the channel will be pinched-off by positive charges stored in the dielectric. When the variable threshold dielectric is written with a less negative threshold voltage, the channel will then be "on".

It will be appreciated that an enhancement-mode gated-access transistor may be fabricated through the provision of a lightly doped n-type substrate and $p^{+}$-type source and drain regions in the gated-access transistor structures of Figures 1-7. Since the voltage level applied to the access gate dielectrics of the enhancement-mode transistor may be determined independently from the voltage applied to the variable threshold memory gate dielectric, the voltage level of the access gate dielectrics may be chosen at a high level to maximise the source-drain current to reduce memory access time while the voltage applied to the memory gate dielectric may be chosen independently thereof to minimise read disturb.

The channel underlying the memory gate portion of the enhancement-mode gated-access transistor described above will be non-conductive unless a negative voltage exceeding the threshold voltage of the memory gate region is applied thereto. In order to store binary information, the threshold voltage level of the memory gate dielectric is selectively written at a high negative value or at a low negative value. Accordingly, the state of the enhancement-mode transistor is read by applying a voltage level to the memory gate dielectric which is intermediate the two threshold voltage levels and, with the access gate channel regions turned on, sensing whether or not the source-drain circuit is conductive. However, in the case of both the n-channel and p-channel depletion-mode gated-access transistors described above, the memory gate region is "on" with the application of a zero voltage thereto. Accordingly, both the n-channel and p-channel depletion-mode gated-access transistors are preferably read with the access gate channel regions turned on, but with a zero voltage applied to the memory gate region, the state of the device being indicated by the magnitude of the source-drain current.

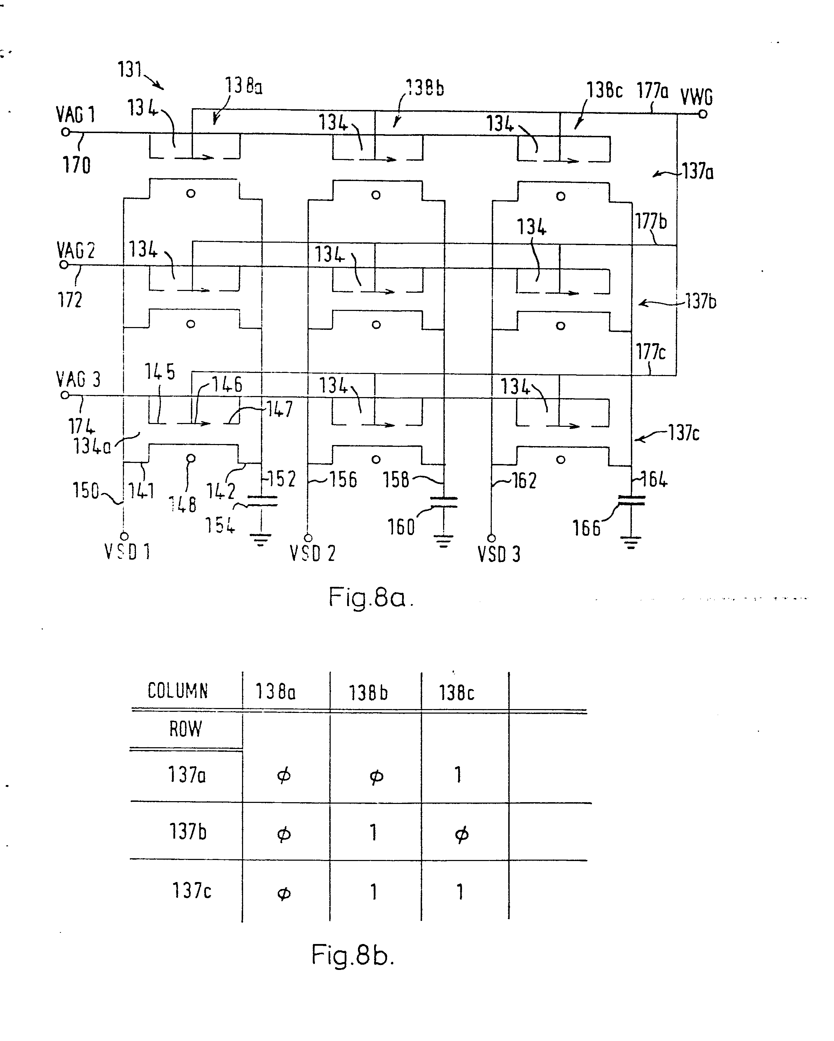

An array of depletion-mode, gated-access memory transistors is shown in schematic form in Figure 8a for explaining a writing scheme therefor. The array 131 comprises a 3 x 3 arrangement of n-channel depletion-mode, gated-access memory transistors 134 arranged in rows 137a - 137c and columns 138a - 138c. It will be appreciated that the writing scheme described in connection with Figure 8a is not limited to the particular array shown in Figure 8a.

Reference is made to the n-channel depletion-mode gated-access memory transistor 134a in row 137c and column 138a for an explanation of the schematic representation. The source electrode of this transistor is designated 141 and its drain electrode is designated 142. Collinear line segments 145, 146 and 147 represent a first access gate electrode, a memory gate electrode, and a second access gate electrode, respectively. The memory gate electrode 146 is provided with an arrow to indicate that a variable threshold dielectric underlies it. A circle 148 indicates that the transistor 134 is a depletion-mode transistor. In the array of Figure 8a, the source electrode of each transistor 134 in the column 138a is connected via a line 150 to a voltage source VSD1 and the drain electrode of each transistor 134 in the column 138a is connected via a line 152 to a first terminal of a capacitor 154, a second terminal of the capacitor 154 being connected to ground. The source electrode of each transistor 134 in the column 138b is connected via a line 156 to a voltage source VSD2 and the drain electrode of each said transistor is connected via a line 158 to a first terminal of capacitor a 160, a second terminal of the capacitor 160 being connected to ground. The source electrode of each transistor 134 in column 138c is connected via a line 162 to a voltage source VSD3 and the drain electrode of each said transistor is shown as connected via a line 164 to a first terminal of a capacitor 166, a second terminal of the capacitor 166 being connected to ground. The capacitors 154, 160 and 166 represent lumped circuit elements, particularly transistors in the "off" state which have a very high resistance to ground. The access gates of each transistor 134 in the row 137a are connected together and through a line 107 to a voltage source VAG1. The access gates of each transistor 134 in the row 137b are connected together and via a line 172 to a voltage source VAG2. The access gates of each transistor 134 in the row 137c are connected together and via a line 174 to a voltage source VAG3. The memory gate electrode of each transistor in each row 137a-c is connected via a respective one of memory gate lines 177a, 177b and 177c to a voltage source VWG.

In the gated-access transistor array 115 of Figure 7, writing is accomplished in the same manner as for the array shown in Figure 8. An important requirement for writing in the array of Figure 7 is, however, that the vertical gate lines 122 must be turned off (i.e. have zero voltage applied) during all writing steps.

In writing information in an n-channel depletion-mode, gated-access transistor, a negative write voltage (typically of the order of -25 volts) is applied to the memory gate electrode, while the substrate and the access gate electrodes are held at zero potential. This is termed the "clear" step, and results in the formation of a deep potential well in the channel of the memory gate region. The potential well may be filled or empty. A filled well contains (for the n-channel case) the number of negative charges necessary to balance the positive charges in the dielectric. In an empty well, all negative charges have been removed. The empty state will exist for approximately 1 millisecond, during which all "inhibit" operations must be performed. During the inhibit step the threshold voltage level to be stored in the memory gate region is selected. If a filled well is desired, a voltage level substantially lower (generally near zero) than the absolute magnitude of the existing threshold voltage is applied to the source and drain and then the access gate channel regions are turned on to permit electrons to enter the channel in the memory gate region to neutralize positive charges stored in the dielectric. If an empty well is desired, a positive voltage equal to or slightly greater than the absolute magnitude of the existing threshold voltage is applied to the source and drain and then the access gates are turned on to withdraw electrons from the channel in the memory gate region. The inhibit step is completed by turning off the access gates before the source-drain potential is changed. A "write" step is next performed by applying a positive write voltage (of the order of +25 volts) to the memory gate electrode while the potential well conditions set by the clear step and the inhibit step persist. If prior to the write step the well was filled with electrons, they will be drawn into the memory gate dielectric, thus neutralizing to a degree positive charges stored in the dielectric and resulting in a low level negative threshold voltage. However, if the well is empty when the write step is performed, the space charge region in the memory gate portion of the channel resulting from positive charges in the memory gate dielectric will act as additional dielectric such that the high level negative threshold voltage established by the clear step will be retained.

The above described method of writing information in a rectangular array of n-channel depletion-mode, gated-access transistors will now be illustrated with respect to Figures 8a and 8b. For purposes of illustration, it is assumed that information is to be stored in accordance with the pattern of Figure 8b, in which the symbols $\emptyset$ (indicating a low level negative threshold voltage) and 1 (indicating a high level negative threshold voltage are arranged in rows 137a-c and columns 138a-c to indicate the desired states of corresponding transistors 134.

In accordance with the above writing scheme, the "clear" step is performed by setting VWG at a write voltage level of about -25 volts, forming a deep potential well in the silicon of the memory gate region of each transistor, VAG1, VAG2, and VAG3, as well as the substrate, being held at zero potential. Then the "inhibit" step is performed row-by-row as follows: in accordance with the desired information pattern of row 137a of Figure 8b, VSD1 and VSD2 are set at zero volts, while VSD3 is set at a positive voltage equal to or slightly greater than the absolute magnitude of the existing memory gate threshold voltage, typically about +10 volts; then a positive voltage is applied to VAG1 to turn on the access gates of transistors 134 in row 137a and to store inhibit information in accordance with the voltage level VSD1, VSD2 and VSD3. Where the source-drain voltage is low, the potential well will be filled with electrons, while, if the source-drain voltage is high (i.e., about +10 volts in this case) the potential well will not be filled. Thereafter the access gates are turned off to preserve the states generated in the respective memory gate regions of row 137a. Meanwhile, the access gates of the transistors 134 in rows 137b and c are held at zero potential, so

-14-

that information provided by VSD1, VSD2 and VSD3 will only be stored in row 137a at this time. Then, the inhibit step, as described above, is performed separately for rows 137b and 137c in accordance with the information pattern of Figure 8b. After the inhibit step has been performed in all rows in which information is to be stored and while the empty well condition remains for those transistors provided with a high source-drain voltage during inhibit, a "write" step is performed. During the write step, a positive write voltage (of the order of +25 volts) is applied to the memory gate electrode, while all access gates, source and drain regions, as well as the substrate are held at zero potential.

The above described writing scheme may also be implemented in an array of p-channel depletion-mode, gated-access transistors connected as shown in Figure 8a. The clear step is performed by the application of a high positive voltage to set the threshold voltage of the memory gate region at a low negative value (typically about -2 volts). The above described row-by-row inhibit step is performed by applying a voltage to source and drain regions which either (a) exceeds the memory gate threshold voltage set by the clear step (e.g. source-drain voltage about zero volts) or (b) is substantially less than said memory gate threshold voltage (e.g. source-drain voltage about - 10 volts). Then the access gate channels are turned on, such that in the case of a high source-drain voltage, holes will remain in the memory gate depletion region, and in the case of a low source-drain voltage, said holes will be removed from the memory gate depletion region. Accordingly, the high source-drain voltage condition leads to a filled well condition and the low source-drain voltage condition leads to an empty well condition. As in the case of the writing scheme for the n-channel gated-access transistor array, the access gate channels are turned off before the source-drain voltage levels set during the inhibit step are modified. Then the write step is performed by the application of a high negative voltage to the memory gate electrode.

The enhancement-mode gated-access memory transistor is written in accordance with conventional writing schemes; for example, see United States Patents Nos. 3,623,023 and 3,618,051. During writing of the enhancement-mode device, however, the access gate channels are turned on by the application of a voltage to the access gate electrodes exceeding the threshold voltage level.

It will be appreciated with respect to the above described writing schemes for both n and p-channel depletion mode transistors that high voltage levels are applied only to the memory gate electrodes, and then; simultaneously to the memory gate electrodes of all the transistors 134 in the array 131. Since in the case of array 131 switching is accomplished only in low voltage buffer circuits providing the inhibit information, the need for array-substrate isolation is eliminated for both n-channel and p-channel depletion-mode, gated-access transistor arrays in which the above described writing scheme is employed.

In the case of the n-channel, gated-access transistor, the application of a write voltage to the memory gate electrode will cause electrons (if the well was filled during the inhibit step) to move into the memory dielectric. The movement of negative charge into the memory dielectric causes the voltage level of the well to become more positive such that the driving force for writing diminishes, increasing the time necessary for writing. The provision of an n-diffused or implanted region contiguous with the channel region underlying the variable threshold dielectric to provide a pool of charge accessible to said channel region will decrease the time necessary for writing by decreasing the positive shift in well potential during the writing step.

A modification of the n-channel depletion-mode, gated-access transistor of Figures 1-7 improves empty well storage during writing in such devices having a high surface recombination velocity. According to this modification, the depletion region 32 shown in Figures 1 and 4 is constituted by an n-doped region formed, for example, by ion implantation when the surface 25 of the substrate 20 is exposed by the aperture 86 as shown in Figure 3e. Accordingly, the empty well condition is maintained on a reverse-biased junction.

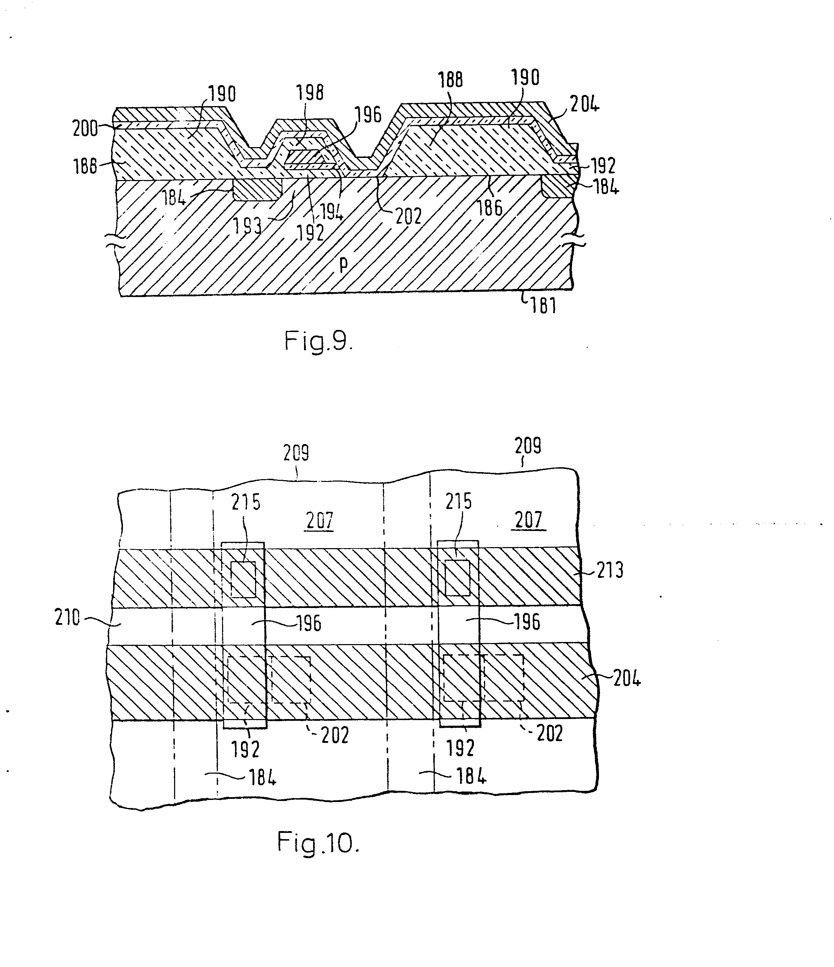

Figure 9 is a cross-section of an array of gated-access non-volatile charge storage devices in accordance with the present invention. The array is fabricated on a substrate 181 of high resistivity p-type silicon. Each charge storage device is provided with an $n^+$ region 184 formed in the substrate, for example, by ion implantation. Silicon dioxide regions 188 are deposited on the surface 186 of the substrate 181, each comprising a field insulator portion 190 and a fixed threshold dielectric portion 192, approximately 1,000 angstroms thick, which overlies the fixed threshold channel region 193 of substrate 181 adjacent to the $n^+$ region 184. The silicon nitride layers 194 are approximately 100 angstroms thick and serve the same purpose as the silicon nitride layer 93 of Figure 4 in the process of making the charge storage device array of Figure 9. Polycrystalline silicon layers 196, about 5,000 angstroms thick, are each disposed on the silicon nitride layers 194 to act as access gate electrodes for the fixed threshold dielectric 192. Each silicon dioxide region 188 further comprises a layer 198 at least 1,000 angstroms thick overlying a respective ploycrystalline silicon layer 196. Overlying the silicon dioxide regions 188 is a layer of silicon nitride 200, about 500 angstroms thick, which also overlies the memory portion 202 of the substrate surface 186, to act as a variable threshold dielectric. An aluminium line 204 is disposed on the silicon nitride layer 200 for applying a memory voltage to it.

Figure 10 illustrates a two-dimensional array of gated access charge storage devices of the type shown in cross-section in Figure 9, in which corresponding elements are identified by the same reference numerals. In the array illustrated in Figure 10, gated-access charge storage devices 207 are arranged in a rectangular array of columns 209 and rows 210. The memory region 202 of each charge storage device 207 in a row 210 is in contact with an aluminium line 204. As shown in Figure 10, each of the polycrystalline silicon layers 196 in a row 210 is in contact with a second aluminium line 213 through an aperture 215 in its silicon dioxide layer 198. An $n^+$ layer 184 constitutes a continuous region or bit line for all the devices in each column.

It will be appreciated that the method of fabricating the gated-access transistor of Figure 4, as illustrated with respect to Figures 3 and 5 may be modified by eliminating the drain region and the access gate electrode disposed between the memory gate and the drain region, in order to fabricate the gated-access charge storage device of Figure 9 and 10. It will be appreciated further that a p-channel depletion-mode, gated-access charge storage device may be fabricated by the inclusion of a $p^+$ depletion region in an n-type substrate underlying the memory portion 202 and the substitution of a $p^+$ region for the $n^+$ region 184 in said n-type substrate.

A writing scheme for the gated-access charge storage device array of Figures 9 and 10 is provided which is based on the three-step writing scheme described with respect to Figure 8. In accordance with said writing scheme for the n-channel gated-access charge storage device array of Figures 9 and 10, a high level negative write voltage (typically about -25 volts) is provided to the aluminium lines 204 of each row 210 of the array. This voltage is thereby applied to each silicon nitride layer 200 in the array to form a deep potential well in the memory portion 202 of each device 207 in the array and is termed a "clear" step (to correspond to the clear step of the gated-access transistor writing scheme described with respect to Figure 8). While this negative potential is applied to the line 204, a zero potential is applied to the lines 213, the substrate 181, and the bit line 184. After the deep potential well has been formed in each memory portion 202, the next or "inhibit" step is performed to either fill or empty each potential well in accordance with a desired pattern of stored information. This inhibit step is performed sequentially in row-by-row fashion, so that when a given row 210 is selected for inhibit, the appropriate voltage is applied to each bit line 184 in accordance with the desired state of the respective gated-access device 207 in the selected row 210, after which the fixed threshold channel region 193 of each gated-access device 207 in the selected row 210 is turned on by the application of a voltage to the line 213 which exceeds the threshold level of the channel regions 193. The voltages applied to the respective bit line 184 during the inhibit step are chosen so that if a filled well is desired, a voltage substantially lower than the absolute value of the threshold voltage of the variable threshold memory portion 202 is applied to the bit line 184,

-18-

and if an empty well is desired a positive voltage equal to or slightly greater than the absolute magnitude of the threshold voltage of the memory portion 202 is applied to the bit line 184. When the well conditions of the respective gated-access devices 207 in the selected one of said rows 210 have been set, the access gates 192 are turned off before the voltages of the bit line 184 are changed in accordance with the desired well conditions of the gated-access devices 207 in the next selected row 210. The inhibit step is thus repeated for any desired number and sequence of rows 210 during the time following the clear step during which the empty well condition persists. While inhibit information is being stored in each one of the rows 210, the fixed threshold channel regions 193 in th. other rows are held at zero potential. During the inhibit step, the substrate 181 is also hek at zero potential. When the inhibit step is completed, and while the empty well conditions set by the inhibit step persist, a "write" step is performed by applying a high level positive voltage (typically about +25 volts) to all lines 204 while the substrate 181, the fixed threshold dielectric portions 192 and the bit line 184 are held at zero potential. Accordingly, if prior to the write step a given potential well was filled with electrons, they will be drawn into the memory gate dielectric, thus neutralizing to a degree positive charges stored in the dielectric. However, if the well is empty when the write step is performed, a space charge region in the substrate adjacent to the memory portion 202 will act as additional dielectric to prevent negative charges from entering the silicon nitride layer 200 at the memory portion 202.

The writing scheme described above for an n-channel depletion-mode, gated-access charge storage device array may also be implemented for an array of p-channel depletion-mode, gated-access charge storage devices such as that of Figures 9 and 10 in which the substrate is lightly doped n-type, a $p^+$ region is substituted for $n^+$ region 184 and a p-type depletion layer is provided in the n-type substrate adjacent to the memory portion 202. The clear step is performed by the application of a high positive voltage to all silicon nitride layers 200 in the array to set the threshold voltage of the memory portions of all devices in the array to be written at a low negative value (typically about -2 volts). It will be appreciated that the provision of separate lines 204 for each row 210 permits writing to be performed in any one or more of the rows without affecting information stored in the unwritten rows. Then the above row-by-row inhibit step is performed by applying a voltage to each bit line 184 in a selected row 210 which either (a) exceeds the memory threshold voltage set by the clear step (e.g. bit line voltage about zero volts), or (b) is substantially less than the memory threshold voltage (e.g. bit line voltage about -10 volts). Then the access gates 192 are turned on, so that, if the bit line 184 is set at the higher voltage level mentioned in (a) above, holes will remain in the substrate beneath the memory portion 202, but if the bit line 184 is set at the lower voltage mentioned in (b) above, the holes will be removed from the substrate beneath the memory portion 202. Accordingly the higher voltage applied to the bit line 184 leads to a filled-well condition, while the lower voltage level leads to an empty well condition. The access gates 192 are turned off before the voltage levels established in respective bit line 184 are changed to preserve the well conditions set by the inhibit step. Thereafter, the write step is performed by the application of a high negative voltage to the memory portions 202 of all devices previously cleared through the provision of a high negative voltage to their lines 204.

As in the case of both n and p-channel depletion-mode, gated-access transistors in accordance with the present invention, writing arrays of either n or p-channel gated-access charge storage devices necessitates the application of high voltages only to the memory dielectrics thereof through an electrode which is electrically isolated from other portions of the array. Since operation is accomplished only in low voltage buffer circuits providing the inhibit information, array substrate isolation is unnecessary in either n or p-channel type non-volatile charge storage device arrays in accordance with the present invention.

As in the case of the above described n-channel depletion-mode, gated-access transistor, empty well storage during writing of the n-channel gated-access charge storage device is improved through the provision of an n-doped region in the p-type substrate 181 beneath the memory portion 202 to maintain the empty well condition on a reverse biased junction. Also, as described with respect to the n-channel, gated-access transistor, application of a write voltage to the variable threshold dielectric of an n-channel, gated-access charge storage device causes electrons to enter the variable threshold dielectric, causing the voltage level of the well to become more positive, thus diminishing the driving force for writing. Accordingly, the n-channel gated-access charge storage device of Figure 9 may be provided with an n-diffused or implanted region contiguous with the portion of substrate 181 underlying the memory gate region 202 to provide a pool of charge accessible to said portion of substrate 181 to decrease the positive shift in well potential during the writing step.

In accordance with one method of reading the n-channel gated-access charge storage device array of Figures 9 and 10, the substrate 181 and the bit line 184 are precharged to a +5 volt level while the lines 213 and 204 are held at a zero volt level to empty the fixed threshold channel region and that portion of the substrate 181 underlying the memory gate region 202 of negative charge. Reading of the devices 207 in one of rows 210 is accomplished by applying a +10 volt level to the corresponding one of lines 213 to turn on the fixed threshold channel regions 193 in that row. The state of each variable threshold memory portion 202 in that row is then indicated by the amount of charge drawn by the corresponding bit line 184 as charge therefrom passes through the fixed threshold channel portion 193 to the substrate beneath memory gate portion 202. Thereafter, a zero volt level is applied to the bit lines 184 to return the devices to charge equilibrium so that the state of variable threshold memory portions 202 may be read again, if desired. Reading of the p-channel gated-access charge storage device array described above may be performed in the same manner, the applied voltages being inverted in polarity.

A faster operational cycle may be achieved if, instead of reading the charge drawn by bit line 184, the charge from the portion of substrate 181 underlying memory gate region 202 which is at equilibrium is transferred to a discharged bit line. Both in the case of n-channel and p-channel charge storage device arrays, such a read operation is commenced by establishing the portion of the substrate underlying the variable threshold memory portion in charge equilibrium and discharging the corresponding bit line. With respect to the array of Figures 9 and 10, this may be achieved in a given row 210 by applying a zero volt level to the corresponding lines 213 and 204 as well as to the substrate 181, while the desired bit lines 184 are discharged by the application of a positive voltage thereto in the case of n-type bit lines or a negative voltage in the case of p-type bit lines. Thereafter, an appropriate voltage is applied to the corresponding line 213 to turn on the access gate regions of the desired row 210, thus to permit charge from the substrate underlying the corresponding memory portions 202 to be transferred to the discharged bit lines 184. The state of each memory portion 202 in that row is then indicated by the amount of charge transferred to the corresponding bit line 184. Thereafter, the line 213 is returned to a zero volt level to permit the substrate underlying the memory portions 202 so read to return to equilibrium.

CLAIMS

1.    A memory element comprising an insulated gate field effect transistor, characterised in that a variable threshold dielectric layer (30) is provided overlying a portion (32) of the length of the conduction channel of the transistor (18) and having superposed on it a memory gate electrode layer (44) electrically separate from the transistor gate electrode (35).

2.    A memory element according to claim 1, further characterised in that the variable threshold dielectric layer (30) is of silicon nitride of a thickness of approximately 500 angstroms.

3.    A memory element according to claim 1 or claim 2 further characterised in that the electrodes (35) of the fixed threshold access gate regions (38, 39) are of polycrystalline silicon.

4.    An array of memory elements arranged in rows and columns on a common substrate, characterised in that the memory elements (18) are in accordance with claim 1, claim 2 or claim 3, that the elements in each column (50) share common source regions (21) and common drain regions (22), and that the element in each row (49) have their access gate electrodes (35) connected by a common line (55 Figure 2, 106 Figure 6) and their memory gate electrodes (44) connected by a common line (44).

5.    An array according to claim 4 characterised in that the memory gate row line (44) overlies, and is narrower than, the fixed threshold row line (106) so that the latter screens the memory transistors (99) and isolation regions (112) from large write voltages applied to the memory gate row line (44).

6.     An array of memory elements according to claim 4 further characterised in that each element (117 Figure 6) has two fixed threshold dielectric access gate regions (38, 39) one of which (38) has its electrodes (120) connected to a said common row line (124) while the other (39) shares a line (122) common to all the elements (117) of a column (119), whereby a single element may be selected by energising the lines (124, 122) of the corresponding row (118) and column (119).

7.     An array of memory elements according to claim 6 further characterised in that adjacent rows (118) of elements have a common source/drain line (130) and that no field isolation regions (as 112, Figure 6) are provided between adjacent rows.

8.     An array of memory elements arranged in rows and columns on a semiconducting substrate of one conductivity type, characterised in that each element (207) comprises a region (184) of opposite conductivity type, the said regions being common to all the elements of a column (209), and that the elements of each row each have a fixed threshold channel region (192) connected to a common row line (213) and a variable threshold channel region (202) connected to common row line (204).

Fig.1.

Fig.2.

Fig.3a.

Fig.3b.

Fig.3c.

Fig.3d.

Fig.3e.

Fig.3f.

Fig.4.

Fig.5a.

Fig.5b.

Fig.6.

Fig.7.

Fig.8a.

| COLUMN ROW | 138a | 138b | 138c | |
|------------|------|------|------|---|
| 137a | φ | φ | 1 | |
| 137b | φ | 1 | φ | |
| 137c | φ | 1 | 1 | |

Fig.8b.

0003413

Fig.9.

Fig.10.